(19) Europäisches Patentamt  
European Patent Office  
Office européen des brevets

(11) **EP 4 534 463 A2**

(12) **EUROPEAN PATENT APPLICATION**

(43) Date of publication:
**09.04.2025 Bulletin 2025/15**

(21) Application number: **24198737.9**

(22) Date of filing: **05.09.2024**

(51) International Patent Classification (IPC):
***B66B 5/00*** *(2006.01)*

(52) Cooperative Patent Classification (CPC):
**B66B 5/0037**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **12.09.2023  CN 202311172637**

(71) Applicant: **Otis Elevator Company
Farmington, Connecticut 06032 (US)**

(72) Inventors:
- **Zhu, Fengkun**
  **Tianjin, 300457 (CN)**
- **Wu, Hongliang**
  **Tianjin, 300457 (CN)**
- **Hubbard, James Leo**
  **Farmington, 06032 (US)**

(74) Representative: **Schmitt-Nilson Schraud Waibel Wohlfrom
Patentanwälte Partnerschaft mbB
Pelkovenstraße 143
80992 München (DE)**

(54) **SYSTEM AND METHOD FOR DETECTING A STATUS OF A BRAKE OF A CONVEYOR DEVICE**

(57) The present disclosure provides a system for detecting a state of a brake of a conveying device. The system may comprise a resistance detection component for detecting a resistance of the brake; a voltage acquisition component for acquiring a pick voltage of the brake; a memory for storing instructions; and a processor configured to execute the instructions. When executing the instructions, the processor calculate a temperature of the brake based on an initial resistance of the brake and the resistance of the brake detected by the resistance detection circuit; determine the state of the brake based on the temperature calculated and the pick voltage acquired by the voltage acquisition component, and generate a signal indicating the state. An electronic device and a method for detecting a state of a brake of a conveying device are also provided.

FIG. 3

Processed by Luminess, 75001 PARIS (FR)

EP 4 534 463 A2

**Description**

The present disclosure relates to technologies related to conveying devices, in particular to technologies for detecting the brake state of a conveying device.

Elevators are used to transport passengers and/or goods. Passenger safety is one of the most important factors for elevators, and it is essential to prevent the elevator car from freely falling or moving up or down uncontrollably. Therefore, most countries have issued relevant regulations for elevator safety to ensure that elevators can be maintained regularly and operated safely. For example, it is required that the minimum release voltage of the brake should be less than 80% of the rated voltage. For another example, it is required that brake wear should be regularly inspected. Currently, maintenance and inspection of elevators are mainly carried out manually on-site, such as workers manually inspecting the wear of brake pads on site. It is necessary to make improvements in the maintenance of elevators.

The present invention provides a system for detecting a brake state of a conveying device. The system may comprise a resistance detection component for detecting a resistance of the brake; a voltage acquisition component for acquiring a pick voltage of the brake; a memory for storing instructions; and a processor configured to execute the instructions. When executing the instructions, the processor can calculate the temperature of the brake based on the initial resistance of the brake and the resistance of the brake detected by the resistance detection circuit; determine the brake state from the calculated temperature and the pick voltage acquired by the voltage acquisition component; and generate a signal indicating an abnormal state when it is determined that the brake is in an abnormal state.

Particular embodiments further may include at least one, or a plurality of, the following optional features, alone or in combination with each other:

In the system for detecting a brake state of a conveying device, optionally, the processor, when executing the instructions, determines the brake state from the calculated temperature and the pick voltage acquired by the voltage acquisition component by performing the following operations: comparing the pick voltage with an upper voltage threshold based on the temperature calculated; and determining the brake state to be abnormal when the pick voltage is greater than the upper voltage threshold.

In the system for detecting a brake state of a conveying device, optionally, the processor, when executing the instructions, further compares the pick voltage with a lower voltage threshold; generates a warning signal when the pick voltage is less than the upper voltage threshold but greater than the lower voltage threshold; and generates a signal indicating that the brake state is normal or not generates a signal when the pick voltage is less than the lower voltage threshold.

In the system for detecting a brake state of a conveying device, optionally, an output device is further included.

According to another aspect of the present disclosure, an electronic device for detecting a brake state of a conveying device is also provided. The electronic device may comprise a first connecting portion for obtaining a resistance of the brake; a second connecting portion for obtaining a pick voltage of the brake; a memory for storing instructions; and a processor configured to execute the instructions. When executing the instructions, the processor can calculate the temperature of the brake based on the initial resistance of the brake and the obtained resistance of the brake; determine the brake state from the calculated temperature and the obtained pick voltage; and generate a signal indicating an abnormal state when it is determined that the brake is in an abnormal state.

Particular embodiments further may include at least one, or a plurality of, the following optional features, alone or in combination with each other:

In the electronic device, optionally, the processor, when executing the instructions, determines the brake state from the temperature calculated and the pick voltage acquired by the voltage acquisition component by performing the following operations: comparing the pick voltage with an upper voltage threshold based on the temperature calculated; and determining the brake state to be abnormal when the pick voltage is greater than the upper voltage threshold.

In the electronic device, optionally, the processor, when executing the instructions, can further compare the pick voltage with a lower voltage threshold; generates a warning signal when the pick voltage is less than the upper voltage threshold but greater than the lower voltage threshold; and generates a signal indicating that the brake state is normal or not generates a signal when the pick voltage is less than the lower voltage threshold.

In the electronic device, optionally, the first connecting portion may comprise one of a signal receiving portion and a resistance detection component.

In the electronic device, optionally, the second connecting portion may comprise one of a signal receiving portion and a voltage acquisition component.

In the electronic device, optionally, the system may further comprise an output device comprising one or two of a display module and a communication module, wherein the display module may comprise one or more of a display screen, an indicator light, and a voice output device.

According to yet another aspect of the present disclosure, a method for detecting a brake state of a conveying device is further provided. The method may comprise: obtaining a resistance of the brake; obtaining a pick voltage of the brake; calculating the temperature of the brake based on the initial resistance of the brake and the resistance of the brake obtained; determining the brake state from the temperature calculated and the pick voltage obtained; and generating a signal indicating the state when it is determined that the brake is in an abnormal state.

Particular embodiments further may include at least one, or a plurality of, the following optional features, alone or in combination with each other:

A non-transitory storage medium is still further provided for storing program instructions, where any one of the methods herein is implemented when the program instructions are executed.

The present disclosure can be fully understood by referring to the detailed description of the specific embodiments below in conjunction with the accompanying drawings, where:

FIG. 1 briefly illustrates the structure of an elevator brake;

FIG. 2 illustrates the variation curve of the pick voltage with the variation of the gap;

FIG. 3 is a structural schematic diagram of a system 3 for detecting the elevator brake state according to an example of the present disclosure;

FIG. 4 illustrates preset areas according to some examples of the present disclosure;

FIG. 5 is a structural schematic diagram of an electronic device 5 for detecting the elevator brake state according to some examples of the present disclosure;

FIG. 6 illustrates the flowchart of a method for detecting the elevator brake state; and

FIG. 7 illustrates an implementation process of step S606 illustrated in FIG. 6.

To assist those skilled in the art in accurately understanding the subject matter claimed in the present disclosure, the specific embodiments of the present disclosure will be described in detail below in conjunction with the accompanying drawings.

The terms "first", "second", etc. in the description, claims, and accompanying drawings of the present disclosure are used to distinguish similar objects, rather than to describe a specific order or sequence thereof. It should be appreciated that the terms used in this way can be interchanged with each other in appropriate cases, so that the embodiments described herein can be implemented in orders other than those illustrated or described in the embodiments herein. In addition, "first" and "second" are only used for descriptive purposes, and cannot be understood as indicating or implying relative importance or implying or indicating the quantity of technical features indicated. Therefore, the features defined with "first" and "second" can explicitly or implicitly include one or more of such features. In the depiction of the embodiments of the present disclosure, unless otherwise stated, "a plurality of" means two or more.

The terms "example", "as an example", or "illustratively", used in the following text mean "used as an example, embodiment, or illustration". Any embodiment depicted as an "example", or "as an example" or "illustratively" need not be interpreted as being superior or better than other embodiments.

The term "conveying device" in the present disclosure includes devices used for transporting passengers and/or goods, such as elevators. The brake of the conveying device brakes the conveying device in its closed state to stop the conveying device from running. When the brake switches from the closed state to the open state, it releases the braking on the conveying device. The following embodiments of the present disclosure will use an elevator as an example of the conveying device, and accordingly, the elevator brake will be used as the conveying device brake for explanation.

In the present disclosure, brake resistance and brake temperature refer to the resistance of the brake coil and the temperature of the brake coil, illustratively rather than restrictively.

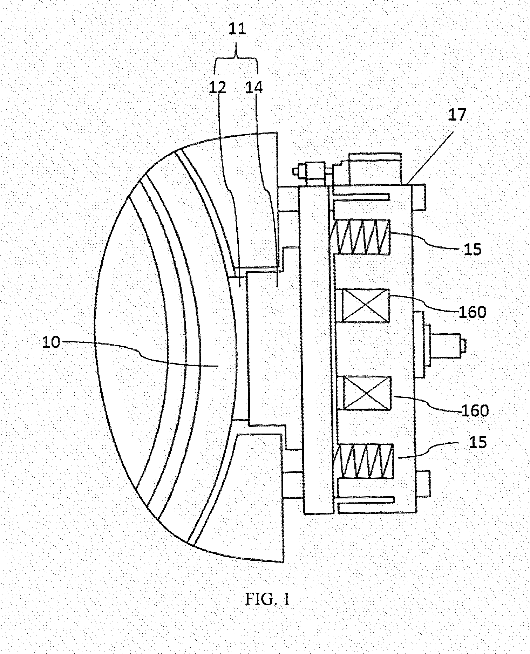

FIG. 1 briefly illustrates the structure of an elevator brake. As shown in FIG. 1, the brake comprises a brake component 11, an elastic component 15 such as a spring, a static plate 17, and a drive circuit (not shown). The brake component 11 includes a brake lining plate 12 and an armature plate 14 combined together, in which the brake lining plate 12 is arranged on the side facing the component to be braked, and the armature plate 14 is arranged on the side facing the static plate 17. The drive circuit includes a coil 160. It should be noted that the names of the various components of the brake described herein may differ in practical applications due to various factors such as the application environment. For example, the armature plate 14 may be called an iron plate, a movable plate, etc., the brake lining plate 12 may be called a brake shoe, a brake lining, etc., and the brake wheel 10 may also be called a rope wheel, a brake drum, and the like. It should be appreciated that compared to the structure illustrated here, the brake actually includes more components. The illustration of the brake in the present disclosure is only intended to illustrate its principles and working process related to the present disclosure in a concise and direct manner, and is not intended to illustrate or restrict the specific structure and shape of the brake.

Voltage is applied to the coil 160 to make it energized. As the voltage increases, the magnetic field generated by the coil 160 increases. The force of the magnetic field causes the armature plate 14 to overcome the force of the elastic component 15 and move away from the brake wheel 10, thereby releasing the braking. The voltage, which is applied to the coil 160 to change the brake component from a closed state to an open state so as to release braking, is called the opening voltage, also known as the release or pick voltage. When the electric power applied to the coil 160 is cut off, the electromagnetic force acting on the armature plate 14 disappears. Under the action of the spring 15, the armature plate 14 moves towards the direction of the brake wheel 10, causing the brake lining plate 12 of the brake component to press against the brake wheel 10, thereby achieving the braking of the brake wheel 10 through the friction force between the brake lining plate 12 and the brake wheel 10. With the use of the elevator, the brake lining plate 12 gradually wears out due to friction with the brake wheel 10, causing the gap between the brake lining plate 12 and the brake wheel 10 to increase, which leads to an increase in the pick voltage.

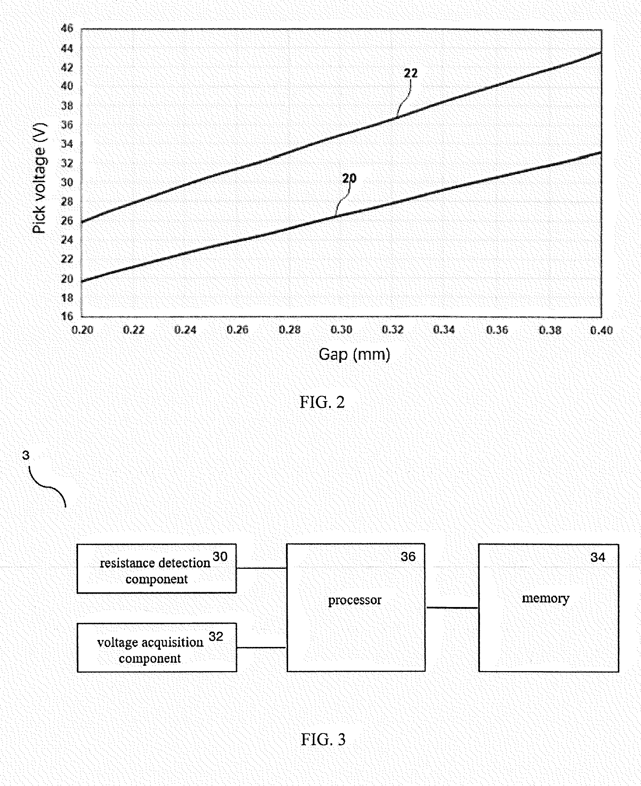

FIG. 2 illustrates the variation curve of the pick voltage with the variation of the gap, where the horizontal axis represents the gap in millimeter and the vertical axis represents the pick voltage $V_{pick}$ in volt. Curve 20 is the relation curve between the pick voltage $V_{pick}$ and the gap when the brake is at 20 degrees Celsius, and curve 22 is the relation curve between the pick voltage and the gap when the brake is at 100 degrees Celsius.

FIG. 3 is a block diagram of a system 3 for detecting the elevator brake state according to some examples of the present disclosure. As shown in FIG. 3, the system 3 includes a resistance detection component 30, a voltage acquisition component 32, a memory 34, and a processor 36. The resistance detection component 30 is used to detect the resistance of the brake. The voltage acquisition component 32 is used to acquire the pick voltage of the brake. The memory 34 stores program instructions. The processor 36 is configured to execute the instructions and, when executing the instructions, calculate the temperature of the brake based on the brake resistance detected by the resistance detection component 30 and the initial resistance of the brake; determine the brake state from the temperature calculated and the pick voltage acquired; and, generate a signal indicating an abnormal state when it is determined that the brake state is abnormal.

In an embodiment of the present disclosure, by way of example, the resistance of the brake coil is used as the resistance of the brake, such as the coil 160 in FIG. 1. The rising and falling of the temperature of the coil affect its own resistance. Therefore, the brake temperature can be determined based on the resistance detected by the resistance detection component 30. It should be noted that in the various examples of the present disclosure, the coil temperature is used as the brake temperature, illustratively rather than restrictively.

The resistance detection component 30 can be a resistance detection circuit, or other component or means that can detect resistance. For example, the resistance detection component 30 may be a signal receiver in some cases, which receives signals indicating the magnitude of the brake resistance transmitted by the elevator controller or brake controller.

The voltage acquisition component 32 is used to acquire the pick voltage of the brake, which can be implemented as a circuit or, if possible, a voltage sensor. Taking the brake in FIG. 1 as an example, as the voltage applied to the coil 160 increases, the brake component 11 moves away from brake wheel 10 towards the static plate 17. During the movement of the brake component 11, the switch arranged on the brake will be triggered. According to the example of the present disclosure, the voltage acquisition component 32 is configured to acquire the voltage of the coil 160 as the pick voltage when the switch is triggered. For example, the voltage acquisition component 32 can be connected to the switch of the brake to acquire the voltage when the switch is triggered.

As an alternative, the voltage acquisition component 32 can also be implemented as a signal receiver for receiving signals indicating the magnitude of the pick voltage when the switch is triggered transmitted by the elevator controller or brake controller. The implementation of the voltage acquisition component 32 is not limited to the depiction here, as long as it can enable the system 3 to obtain the pick voltage.

In addition, the switch, namely the switch arranged on the brake to be triggered as mentioned above, can be an existing switch disposed on the brake that can be triggered during the pick process, or can be a switch configured additionally to be triggered. It should be noted that although the various embodiments of the present disclosure use the voltage when the switch is triggered as the value of the pick voltage, the voltage at other times during the pick process is also feasible.

For example, the relationship between the temperature and resistance of the coil in this example can be represented by formula (1):

$$R_T = R_{initial} \times (1 + \frac{1}{254.5} \times (t_T - t_{initial})) \qquad (1)$$

wherein, $R_T$ is the resistance detected by the resistance detection component 30, $R_{initial}$ is the initial resistance of the coil, $t_T$ is the brake temperature when the resistance detection component 30 detects the resistance $R_T$, and $t_{initial}$ is the brake temperature at the initial resistance.

The initial resistance of the coil is a resistance value that is predetermined and stored in the system 3, such as the resistance value stored in the memory 34. When the processor 36 executes instructions in the memory 34, it obtains the resistance value of the initial resistance from the memory 34 and calculates the temperature $t_T$ according to formula (1). It should be noted that the initial resistance of the coil can be, for example, the resistance value of the coil at 20 degrees Celsius.

For coils, the pick voltage increases as the gap increases at the same temperature. According to the examples of the present disclosure, the relationship between a temperatures and a pick voltage can be predetermined. In other words, for each temperature, the upper voltage threshold at that temperature can be predetermined. In the embodiments of the present disclosure, for the same temperature, an upper voltage threshold for that temperature is predetermined, and a lower voltage threshold for that temperature is also determined. If the pick voltage is greater than the upper voltage threshold for the temperature, it indicates that the brake is abnormal. If the pick voltage is between the upper voltage threshold and the lower voltage threshold, it indicates that it is highly possible that the brake has entered an abnormal state or is about to enter an abnormal state. If the pick voltage is less than the lower voltage threshold, it indicates that the brake is normal. In some examples, when the brake is abnormal, a signal indicating that the brake is abnormal is issued, and when the brake is about to enter an abnormal state, a warning signal indicating an early warning is issued.

According to the examples of the present disclosure, the processor 36 compares the pick voltage with the upper voltage threshold based on the calculated temperature. That is to say, for the calculated temperature, the acquired pick voltage at that temperature is compared with the upper and lower voltage thresholds for that temperature. When the pick voltage is greater than the upper voltage threshold, the processor 36 generates a signal indicating that the brake state is abnormal. When the pick voltage is less than the upper voltage threshold but greater than the lower voltage threshold, the processor 36 generates a warning signal. When the pick voltage is less than the lower voltage threshold, the processor 36 may not process or may generate a signal indicating that the brake is normal.

For example, for temperature $t_T$, the upper voltage threshold and lower voltage threshold can be determined by the following formulas (2) and (3):

$$V_1 = 0.75 * V_R * K \qquad (2)$$

$$V_2 = 0.8 * V_R * K \qquad (3)$$

wherein, $V_1$ is the lower voltage threshold, $V_2$ is the upper voltage threshold, K is the calculation factor, and $V_R$ is the rated voltage. The constant 0.75 in formula (2) and the constant 0.8 in formula (3) can be configured according to practical applications. For example, the constant in formula (2) is set to 0.78, 0.70, etc., while the constant 0.8 in formula (3) can be set to 0.82, 0.79, etc., as long as it can achieve the purpose of detecting the brake state. However, it should be appreciated that they should all be taken within a reasonable range.

K is calculated according to the following formula (4):

$$k = \frac{R_T}{R_{limited}} = \frac{(1 + \frac{1}{254.5} \times (t_T - t_{initial}))}{(1 + \frac{1}{254.5} \times (t_{limited} - t_{initial}))} \qquad (4)$$

wherein, $R_T$ is the resistance detected by the resistance detection component 30, $t_T$ is the brake temperature when the resistance detection component 30 detects the resistance $R_T$, $R_{limited}$ is a set resistance value that can be set according to relevant specifications and standards for elevator brake temperature, such as 110 degrees. $t_{limited}$ is the temperature of the coil when the resistance value is $R_{limited}$.

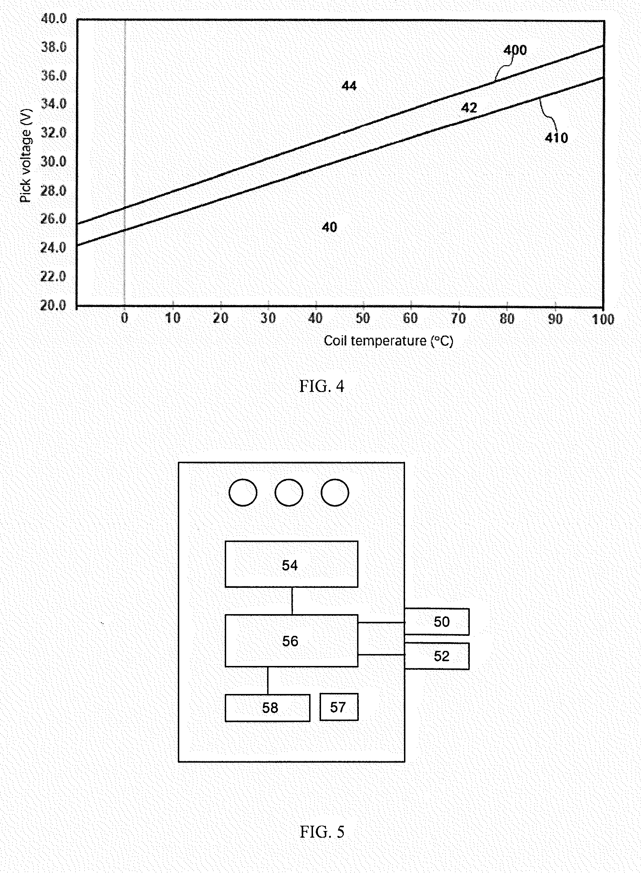

The relationship between coil temperatures and pick voltages can be predetermined, thus forming a table of the relationship between the temperatures and the voltages. FIG. 4 illustrates, as an example, the relationship between the pick voltages and coil temperatures. In this example, the rated voltage of the elevator brake is 48 volts, with temperature in degrees Celsius on the horizontal axis and pick voltage in volts on the vertical axis. For the upper voltage threshold and lower voltage threshold set for each temperature, an upper limit curve 400 and a lower limit curve 410 can be formed to represent the areas indicating that the brake state is normal and abnormal, as well as the warning area. As shown in FIG. 4, the pick voltage falls in region 40, indicating that the brake state is normal; the pick voltage falls in area 42, indicating that the brake state is approaching abnormal; and the pick voltage falls in area 44, indicating that the current brake state is abnormal.

The system 3 for detecting the elevator brake state can be implemented in existing equipment, such as in a control cabinet of an elevator control system. In this case, a function key can be configured for the system 3, so that maintenance personnel can be informed to operate the function key to make the system 3 work during elevator maintenance, thereby detecting the elevator brake state. For example, when the elevator is not carrying passengers, or during maintenance, maintenance personnel press the function key to detect the current resistance of the brake and calculate the current temperature of the brake according to formula (1). On the other hand, the brake is switched from a closed state to an open state (i.e., pick) to obtain the pick voltage, and the brake state is determined based on the temperature and pick voltage. Upon determining the state, the controller outputs a signal indicating the state for maintenance personnel to get to know the brake state.

As an alternative, the system 3 can be implemented in an electronic device separated from the elevator. The system 3 can determine the elevator brake state by electrically connecting the electronic device to the elevator brake. For example, the system 3 can be implemented in, for example, a handheld portable electronic device, which is then electrically connected to the elevator system. As an example, the elevator system can be a brake subsystem of the elevator system, such as a terminal portion corresponding to the brake in the control cabinet, so as to determine the elevator brake state based on the pick voltage acquired, and the like. It can be seen that the inspection process of detecting the elevator brake no longer relies on manual gap detection to determine the brake state with using the system 3, thus saving manpower and various costs for elevator maintenance.

FIG. 5 is a block diagram of an electronic device 5 for detecting the elevator brake state according to some examples of the present disclosure. As shown in the figure, the electronic device 5 includes a first connecting portion 50, a second connecting portion 52, a memory 54, and a processor 56. Optionally, the electronic device 5 further includes a trigger button 57 and an output device 58. The power supply of the electronic device 5 can come from batteries or mains power supply.

The first connecting portion 50 is used to obtain the resistance of the elevator brake. In some examples, the first connecting portion 50 may be connected to the corresponding interface of the elevator brake, and the resistance of the elevator brake is detected by a resistance detection component arranged in the first connecting portion 50. In some examples, the first connecting portion 50 is configured as a signal receiving portion, which can be electrically connected to the elevator brake to receive signals indicating the magnitude of the resistance of the elevator brake from the elevator brake, like the first connecting portion 51 receiving signals from the controller of the elevator brake.

The second connecting portion 52 is used to obtain the pick voltage of the brake. In some examples, the second connecting portion 52 may include a voltage acquisition component to acquire the pick voltage of the brake with the second connecting portion 52 connecting with the brake when the brake is in a picking process. In other examples, the second connecting portion 52 can be configured as a signal receiving portion, which can be electrically connected to the elevator brake to receive signals indicating the magnitude of the pick voltage from the elevator brake, like the second connecting portion 52 receiving signals from the controller of the elevator brake.

The signal receiving portion may receive signals through line connection in the present disclosure. However, it is also possible to receive signals through wireless communication.

In addition, according to some embodiments of the present disclosure, the electronic device 5 can be connected to the controller of the elevator through the first connecting portion 50 and the second connecting portion 52 to obtain the resistance and pick voltage of the brake. In some specific examples, the first connecting portion 50 and the second connecting portion 52 can be connected to the corresponding interfaces of the elevator's control box to obtain the resistance and pick voltage.

Instructions are stored in the memory 54. The processor 56 is configured to execute these instructions and, when executing these instructions, calculate the temperature $t_T$ according to formula (1), and determine, based on the temperature calculated, whether the pick voltage acquired is located in the area 40 representing that the brake is normal, or in the area 44 representing that the brake is abnormal, or in the early warning area 42 representing that the brake is approaching abnormal, as shown in FIG. 4

Specifically, for the calculated temperature $t_T$, the acquired pick voltage is compared with the upper voltage threshold and lower voltage threshold for temperature tr. When the pick voltage is greater than the upper voltage threshold, the processor 56 generates a signal indicating that the brake state is abnormal. When the pick voltage is less than the upper voltage threshold but greater than the lower voltage threshold, the processor 56 generates a warning signal. When the pick voltage is less than the lower voltage threshold, the processor 56 may take no action or may generate a signal indicating that the brake is normal.

According to some examples of the present disclosure, the electronic device 5 can further include an output device 58, which outputs signals generated by the processor 56. The output device 58 includes a communication interface and/or a display device. If the output device 58 is the communication interface, it can be used to transmit signals generated by the processor 56 from the electronic device 5 to other devices, such as computers, laptops, tablets, and smartphones that can inform the users of the signals. The display device above mentioned can be display screens, displays, audio output components, etc. arranged on the electronic device 5. According to a specific example of the present disclosure, the display device of the electronic device 5 can include three display lights, whose display colors are different from each other, so that the users can know which brake state is represented by the display light signal through the color. For example, when the pick voltage falls in an unsafe area, the red light is on, when the pick voltage falls in the early warning area, the yellow light is on, and when the pick voltage falls in a safe area, the green light is on.

According to some examples of the present disclosure, the electronic device 5 can also include a button 57. When the button 57 is operated, the electronic device 5 is powered on to perform its function of detecting the brake. The button 57 can be a button in a trigger, press, voice controlled, or other form.

The system for detecting the brake state of a conveying device according to the examples of the present disclosure can be arranged in the electronic device for detecting the brake state of a conveying device according to the examples of the present disclosure. At the same time, in conjunction with FIGS. 3 and 4, the resistance detection component 30 is arranged at the first connecting portion 50, the voltage acquisition component 32 is arranged at the second connecting portion 52, and the memory 34 and processor 36 can be respectively implemented in the memory 54 and processor 56. The electronic device 5 according to the examples of the present disclosure can be implemented as a portable electronic device, such as a handheld terminal, or in some possible cases, it can be implemented in a handheld terminal such as a mobile phone, a tablet, and so on.

The first and second connecting portions of the electronic device 5 according to the present disclosure are connected to the elevator control cabinet to obtain the elevator brake temperature and pick voltage, respectively, and the obtained pick voltage is compared with the predetermined upper voltage threshold and lower voltage threshold corresponding to the obtained temperature to determine the brake state based on the pick voltage, with an indicator signal issued according to the state. Generally speaking, a table of the relationship between coil temperature and pick voltage has been pre-stored in the electronic device 5. The pick voltage obtained at a temperature is compared with the upper voltage threshold and lower voltage threshold which were predetermined corresponding to that temperature. Accordingly, on the basis of the calculated temperature, the area for example shown by FIG.4 where the obtained pick voltage locates according to the relationship table can be determined.

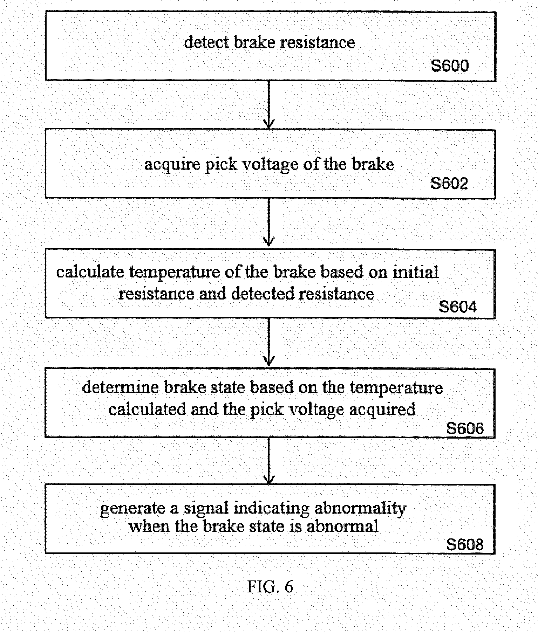

The present disclosure also provides a method for detecting the elevator brake state. FIG. 6 illustrates the flowchart of the method. As shown in FIG. 6, in step S600, the resistance of the brake is obtained. For example, the resistance of the brake is detected through a resistance detection circuit or component. In step S602, the pick voltage of the brake is obtained. For example, the pick voltage is acquired through a voltage acquisition circuit. In step S604, the temperature of the brake is calculated based on the resistance of the brake obtained and the initial resistance of the brake. In step S606, the state of the brake is determined based on the calculated temperature and the obtained pick voltage. In step S608, a signal indicating that the brake state is abnormal is generated when it is determined that the brake is in an abnormal state.

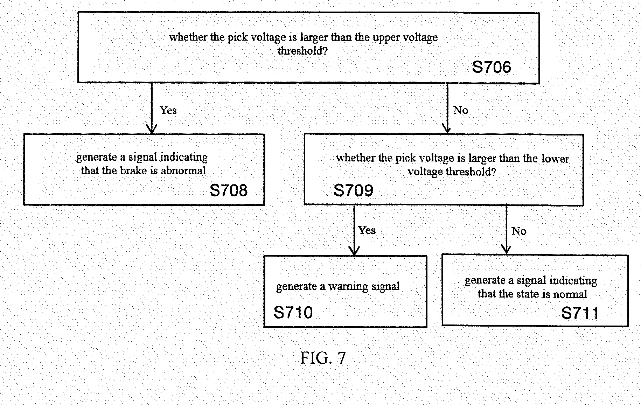

According to some examples of the present disclosure, the pick voltage is compared with the upper voltage threshold and the lower voltage threshold. FIG. 7 illustrates the process based on these examples. As shown in FIG. 7, in step S706, based on the calculated temperature, the acquired pick voltage is compared with the upper voltage threshold. If the acquired pick voltage is greater than the upper voltage threshold, it is determined that the brake state is abnormal, and proceeds to step S708. In step S708, the signal indicating that the brake is abnormal is generated. If the acquired pick voltage is less than the upper voltage threshold, further compare it with the lower voltage threshold, as shown in step S709. If the acquired pick voltage is greater than the lower voltage threshold, a warning signal is generated, as shown in step S710. If the acquired pick voltage is less than the lower voltage threshold, a signal indicating that the brake state is normal can be generated, as shown in step S711, or no signal can be generated.

The various examples of the method for detecting the elevator brake state described in combination with FIGS. 6 and 7 can be implemented by the various examples of the system 3 described above in conjunction with FIG. 3, or by the various examples of the electronic device 5 described above in conjunction with FIG. 5.

In practical applications, the various examples of the method for detecting the elevator brake state described in conjunction with FIGS. 6 and 7 can be implemented as one or more programs through program instructions, implemented by a device with a processor and, if necessary, also two interfaces to be connected with the elevator controller.

The present disclosure further provides a non-transitory storage medium for storing program instructions, where the example described above can be implemented when the instructions stored in the storage medium are executed.

The above examples in the present disclosure are all described using elevator brakes as specific examples. However, the systems, electronic devices, and methods of the above examples can also be applied to conveying devices such as escalators.

The processor in the respective examples of the present disclosure may be, but is not limited to, a single-processor or multi-processor system of any of a wide array of possible architectures, including field programmable gate array (FPGA), central processing unit (CPU), application specific integrated circuits (ASIC), digital signal processor (DSP) or graphics processing unit (GPU) hardware arranged homogenously or heterogeneously. The memory may be but is not limited to a random access memory (RAM), read only memory (ROM), or other electronic, optical, magnetic or any other computer readable medium.

Although specific embodiments of the present disclosure have been shown and described in detail to illustrate the principles of the present disclosure, it should be understood, however, that the features of the respective embodiments and examples of the present disclosure are illustrative rather than restrictive. That is, they can be implemented in other ways without departing from the principles of the present disclosure, including new embodiments formed by the combination of features between the respective embodiments and examples.

**Claims**

1.    A system for detecting a state of a brake of a conveying device, comprising:

a resistance detection component for detecting a resistance of the brake;
a voltage acquisition component for acquiring a pick voltage of the brake;
a memory for storing instructions; and
a processor for executing the instructions for:

calculating a temperature of the brake based on an initial resistance of the brake and the detected resistance;
determining the state of the brake from the calculated temperature and the acquired pick voltage; and
generating a signal indicating that the state is abnormal when it is determined that the brake is in an abnormal state.

2.    The system according to claim 1, wherein the processor, when executing the instructions, determines the state of the brake from the calculated temperature and the acquired pick voltage by performing following operations:

comparing the pick voltage with an upper voltage threshold based on the calculated temperature; and
determining the state of the brake to be abnormal when the pick voltage is greater than the upper voltage threshold.

3.    The system according to claim 2, wherein the processor, when executing the instructions, further:

compares the pick voltage with a lower voltage threshold;
generates a warning signal when the pick voltage is less than the upper voltage threshold but greater than the lower voltage threshold; and
generates a signal indicating that the state of the brake is normal or not generates a signal, when the pick voltage is less than the lower voltage threshold.

4.    The system according to any of claims 1-3, wherein the system further comprises an output device, where the output device comprises one or two of a display module and a communication module, and the display module comprises one or more of a display screen, an indicator light, and a voice output device.

5.    An electronic device for detecting a state of a brake of a conveying device, the electronic device configured for use in the system according to any of claims 1 - 4 and comprising:

a first connecting portion for obtaining a resistance of the brake;
a second connecting portion for obtaining a pick voltage of the brake;
a memory for storing instructions; and
a processor configured for executing the instructions for:

calculating a temperature of the brake based on an initial resistance of the brake and the obtained resistance;
determining the state of the brake from the calculated temperature and the obtained pick voltage; and
generating a signal indicating that the state is abnormal when it is determined that the brake is in an abnormal state.

6.    The electronic device according to claim 5, wherein the processor, when executing the instructions, determines the state of the brake from the calculated temperature and the obtained pick voltage by performing following operations:

comparing the pick voltage with an upper voltage threshold based on the calculated temperature; and
determining the state of the brake to be abnormal when the pick voltage is greater than the upper voltage threshold;
wherein particularly the processor, when executing the instructions, further:

compares the pick voltage with a lower voltage threshold;
generates a warning signal when the pick voltage is less than the upper voltage threshold but greater than the lower voltage threshold; and
generates a signal indicating that the state of the brake is normal or not generates a signal, when the pick voltage is less than the lower voltage threshold.

7. The electronic device according to claim 5 or 6, wherein the first connecting portion comprises one of a signal receiving portion and a resistance detection component.

8. The electronic device according to any of claims 5-7, wherein the second connecting portion comprises one of a signal receiving portion and a voltage acquisition component.

9. The electronic device according to any of claims 5-8, wherein the system further comprises an output device comprising one or two of a display module and a communication module, where the display module comprises one or more of a display screen, an indicator light, and a voice output device.

10. A method for detecting a state of a brake of a conveying device, comprising:

obtaining a resistance of the brake;
obtaining a pick voltage of the brake;
calculating a temperature of the brake based on an initial resistance of the brake and the obtained resistance;
determining the state of the brake from the calculated temperature and the obtained pick voltage; and
generating a signal indicating the state when it is determined that the brake is in an abnormal state.

11. The method according to claim 10, wherein determining the state of the brake from the calculated temperature and the obtained pick voltage, comprising:

comparing the pick voltage with an upper voltage threshold based on the temperature calculated;
determining the state of the brake to be abnormal when the pick voltage is greater than the upper voltage threshold.

12. The method according to claim 11, further comprising:

comparing the pick voltage with a lower voltage threshold;
generating a warning signal when the pick voltage is less than the upper voltage threshold but greater than the lower voltage threshold; and
generating a signal indicating that the state of the brake is normal or not generating a signal, when the pick voltage is less than the lower voltage threshold.

13. The method according to any of claims 10-12, further comprising outputting the generated signal indicating the state of the brake.

14. The system according to any of claims 1-4, the electronic device according to any of claims 5-9, and the method according to any of claims 10-13, wherein the conveying device is an elevator.

15. A non-transitory storage medium for storing program instructions, wherein the method according to any of claims 10-13 is implemented when the program instructions are executed.

FIG. 1

FIG. 2

FIG. 3

FIG. 4

FIG. 5

detect brake resistance

S600

acquire pick voltage of the brake

S602

calculate temperature of the brake based on initial
resistance and detected resistance

S604

determine brake state based on the temperature
calculated and the pick voltage acquired

S606

generate a signal indicating abnormality
when the brake state is abnormal

S608

FIG. 6

whether the pick voltage is larger than the upper voltage threshold?

S706

Yes | No

generate a signal indicating that the brake is abnormal

S708

whether the pick voltage is larger than the lower voltage threshold?

S709

Yes | No

generate a warning signal

S710

generate a signal indicating that the state is normal

S711

FIG. 7